# EUROPEAN PATENT APPLICATION

(11) **EP 4 836 215 A1**
(43) Date of publication of application: **04.11.2026**
(21) Application number: 26161307.9
(22) Date of filing: 27.02.2026
(51) Int. Cl.: H02H 3/02, H02H 5/10

(54) **DEVICE FOR CONTROLLING A HIGH-POWER AMPLIFIER, SYSTEM COMPRISING THE DEVICE FOR CONTROLLING A HIGH-POWER AMPLIFIER, AND METHOD FOR CONTROLLING A HIGH-POWER AMPLIFIER USING THE DEVICE FOR CONTROLLING A HIGH-POWER AMPLIFIER**

(30) Priority: 30.04.2025 US 202563797469 P
(71) Applicant: SES Americom, Inc, Princeton, NJ 08540 (US)
(72) Inventor: Bors, Phillip J., Mineral (US); Foster, Scott, Edinburg (US)
(74) Representative: Vossius & Partner Patentanwälte Rechtsanwälte mbB

(57) **Abstract**

This document relates to a device for controlling a high-power amplifier, the device comprising a first switch (K1), a second switch (K2), and a third switch (K3), wherein the device is configured so that, if the third switch does not receive an electrical signal from a terminal block (TB1), the third switch causes a transmission of a fault indication to a control unit (CU), and if the second switch receives a control signal from the control unit, the second switch transmits a second electrical signal to the first switch, and if the first switch receives the second electrical signal, the first switch turns the high-power amplifier on. Using the device, a high-power amplifier can be controlled remotely and safely.

## Description

### TECHNICAL FIELD

The invention relates to a device for controlling and monitoring a high-power amplifier remotely, and a corresponding system and method. The invention may be used for controlling and monitoring a high-power amplifier, wherein the high-power amplifier may be a part of a satellite ground station.

### TECHNICAL BACKGROUND

Known approaches in high-power amplifier control use mechanical breaker actuators or electro-mechanical switches. High-power amplifier control devices that use these mechanical breakers are difficult to maintain. This is because they need to be operated manually. Replacing the mechanical breakers requires manual work at a respective high-power amplifier control device. The present invention provides a configuration that allows for remote control and monitoring of a high-power amplifier based on a combination of a fault detection circuit and a control circuit comprising electrical switches or relays.

### SUMMARY

One of the objects of the present disclosure is to overcome at least one of the above prior art problems or to improve at least one of the prior art solutions. The object is achieved by the subject-matter of the independent claims. Further embodiments are given by the subject-matter of the dependent claims.

In one embodiment, a device is provided for controlling a high-power amplifier. The device comprises a first switch, a second switch, and a third switch, wherein the device is configured so that, if the third switch does not receive an electrical signal from a terminal block, the third switch causes a transmission of a fault indication to a control unit, and, if the second switch receives a control signal from the control unit the second switch transmits an second electrical signal to the first switch, and, if the first switch receives the second electrical signal, the first switch turns the high-power amplifier on.

The device in the above embodiment generally allows for controlling and monitoring a high-power amplifier remotely.

Further advantages and details will become apparent from the following detailed description of some embodiments of the invention.

### BRIEF DESCRIPTION OF DRAWINGS

Figure 1 shows an example of a device for controlling a high-power amplifier according to a first embodiment of the present invention.
Figure 2 shows an example of a device for controlling a high-power amplifier according to a second embodiment of the present invention.
Figures 2a and 2b show two diagrams referred to as "diagram 1" and "diagram 2", respectively.
Figure 3 shows an example of a device for controlling a high-power amplifier according to a fourth embodiment of the present invention.
Figure 4 shows an example of a device for controlling a high-power amplifier according to a fifth embodiment of the present invention.
Figure 5 shows an example of a device for controlling a high-power amplifier according to a sixth embodiment of the present invention.
Figure 6 shows an example of a device for controlling a high-power amplifier according to a seventh embodiment of the present invention.
Figure 7 shows an example of a device for controlling a high-power amplifier according to an eighth embodiment of the present invention.
Figure 8 shows an example of a device for controlling a high-power amplifier according to a ninth embodiment of the present invention.
Figure 9 shows an example of a device for controlling a high-power amplifier according to a tenth embodiment of the present invention.
Figure 10 shows an example of a device for controlling a high-power amplifier according to a twelfth embodiment of the present invention.
Figure 11 shows a system according to a thirteenth embodiment of the present invention.
Figure 12 shows a flowchart according to a fourteenth embodiment of the present invention.
Figure 13 shows a flowchart according to a fifteenth embodiment of the present invention.
Figure 14 shows another embodiment of a device for controlling a high-power amplifier according to the present invention.
Figure 15 shows another embodiment of a device for controlling a high-power amplifier according to the present invention.
Figure 16 shows another embodiment of a device for controlling a high-power amplifier according to the present invention.

### DETAILED DESCRIPTION

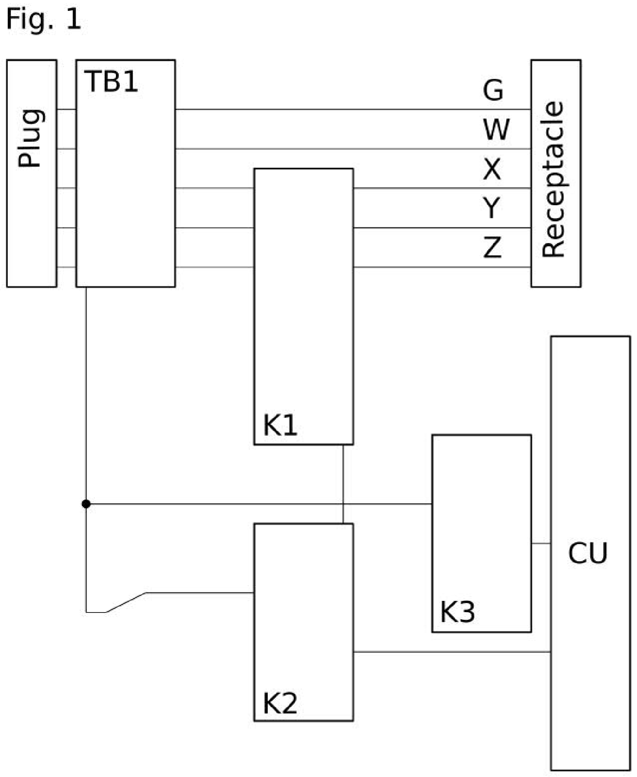

Figure 1 shows a device for controlling a high-power amplifier according to a first embodiment of the present invention, the device comprising a first switch, K1, a second switch, K2, and a third switch, K3, wherein the device is configured so that, if the third switch, K3, does not receive an electrical signal from a terminal block, TB1, the third switch, K3, causes a transmission of a fault indication to a control unit, CU, and, if the second switch, K2, receives a control signal from the control unit, CU, the second switch, K2, transmits a second electrical signal to the first switch, K1, and, if the first switch, K1, receives the second electrical signal, the first switch, K1, turns the high-power amplifier on.

In figure 1, connections between the first switch, the second switch and the third switch, the terminal block, the control unit, a plug, and a receptacle are depicted as solid black lines. The first switch may be connected to the second switch. The first switch may be connected to the receptacle. The first switch may be connected to the terminal block. The second switch may be connected to the terminal block. The second switch may be connected to the control unit. The third switch may be connected to the terminal block. The third switch may be connected to the control unit. The terminal block may be connected to the plug. The terminal block may be connected to the receptacle. A connection may be based on a cable. A cable may be referred to as a wire. A signal, the control signal, or the electrical signal may be transmitted through a respective connection.

As depicted in figure 1 there may be a connection labelled G between the terminal block and the receptacle. This connection may be a ground connection. The terminal block may extend this connection to the plug. The connection labelled may be a direct connection between the receptacle and the plug.

Moreover, there may be a connection labelled W between the terminal block and the receptacle. This connection may be neutral connection. The terminal block may extend this connection to the plug.

Moreover, there may be a connection labelled X between the receptacle and the first switch. This connection may be a hot connection. The first switch may extend this connection to the terminal block. The terminal block may extend this connection to the plug. In general, a hot connection may also be referred to as live connection, or phase connection.

Moreover, there may be a connection labelled Y between the receptacle and the first switch. This connection may be a second hot connection. The first switch may extend this connection to the terminal block. The terminal block may extend this connection to the plug.

Moreover, there may be a connection labelled Z between the receptacle and the first switch. This connection may be third hot connection. The first switch may extend this connection to the terminal block. The terminal block may extend this connection to the plug.

The connection labelled X may correspond to a first phase of a multi-phase current. The connection labelled Y may correspond to a second phase of a multi-phase current. The connection labelled Z may correspond to a third phase of a multi-phase.

One of the three hot connections is necessary. The other two are optional. For instance, the second and the third hot connection may be left out.

The electrical signal received by the third switch from the terminal block may correspond to an electrical current transmitted through one of the hot connections, for example, through the first hot connection.

The second electrical signal may be received by the second switch from the terminal block through the connection between the second switch and the terminal block. The second electrical signal may correspond to an electrical current transmitted through one of the hot connections, for example, through the first hot connection.

The plug may be connected, or connectable, to a power source. The plug may be referred to as male connector. The plug may comprise a plurality of prongs. A prong may also be referred to as a pin, or a terminal. In general, a prong refers to the parts of a plug that can be inserted into a contact of a socket. A first prong may be connected to a first contact of the receptacle by the ground connection. A second prong may be connected to a second contact of the receptacle by the neutral connection. A third prong may be connected to a third contact of the receptacle by the first hot connection labelled X. A fourth prong may be connected to a fourth contact of the receptacle by the second hot connection labelled Y. A fifth prong may be connected to a fourth contact of the receptacle by the third hot connection labelled Z. Here, the fourth prong and the fifth prong and corresponding connections and contacts of the receptacle are optional. A plug comprising the first prong, second prong and third prong may be referred to as a single-phase plug. A plug comprising the first prong, second prong, third prong, fourth prong and fifth prong may be referred to as a multi-phase plug.

The receptacle may be connected, or connectable, to the high-power amplifier. The receptacle may be referred to as a socket, or as a female connector. The receptacle may comprise a plurality of contacts, for example, the above first contact, second contact, third contact, fourth contact and fifth contact. In general, a contact refers to the parts of a socket where prongs of a plug can be inserted, thereby establishing a connection between the receptacle and the respective plug. For example, the plug of a high-power amplifier may be inserted into the receptacle. A contact may be referred to as a slot.

A switch may refer to a device that provides a connection between an input-terminal and an output-terminal of the switch. The connection may be switched on, e.g., a connection may be provided between the terminals. Moreover, the connection may be switched off, e.g., a connection between the terminals may not be provided or it may be interrupted by a respective switch. The switching may be based on a signal that is provided to the switch. The switch may have an input-port for receiving the signal. The switch may have an output-port for forwarding the signal. The switch may have a further input-port for receiving further signals, for example, from the control unit. A signal may be an electrical signal. Specific examples of a switch are a relay, a transistor switch, a bipolar transistor, or a metal-oxide-semiconductor field-effect transistor, MOSFET.

The terminal block may refer to a device that provides a connection between at least one input-terminal and at least one output-terminal of the terminal block. A terminal block may be referred to as terminal box. Thereby, a first device connected to an input-terminal of the terminal block may be connected through, or via, the terminal block and the output terminal of the terminal block to another device. The terminal block may serve as a junction point for connecting a plurality of wires. By connecting the wires, a signal, or an electrical signal, or a control signal may be transmitted between two devices, e.g., between a plug and a receptacle. The terminal block may have a plurality of input terminals, and a plurality of output terminals. Each input terminal may have a corresponding first output terminal and a corresponding second output terminal. The terminal block may provide an electrical connection between an input terminal and an output terminal. Thereby, an electrical signal received at the input terminal may be transmitted to the output terminal. The terminal block may provide an electrical connection between the input terminal and the first output terminal and a connection between the input terminal and the second output terminal. Thereby, an electrical signal received at the input terminal may be transmitted to the first output terminal and the second output terminal.

A high-power amplifier may refer to a device configured to output an output-signal, wherein the output-signal may be generated by increasing the power of an input-signal. A respective signal may be a radio frequency signal or an electrical signal. The power increase may be selected from a range from +30 dB (decibels) to +70dB. A power of an input-signal may be in the order of milliwatts or centiwatts. A power of an output-signal may be in the order of hundred watts, kilo watts, or 10 kilo watts. The output-signal may be generated without distorting the input-signal. A respective signal may be a signal for driving an antenna. The antenna may be configured for earth-to-satellite communications. The antenna may be configured for satellite-to-satellite communications. The high-power amplifier may be a space-based amplifier or a ground-based amplifier. Specific examples of high-power amplifiers are a solid-state amplifier, SSPA, a vacuum tube amplifier, a klystron, a traveling wave tubes, a TWTA. A high-power amplifier may be a part, or comprised by, a satellite ground station, wherein the satellite ground station may comprise an antenna system for sending electromagnetic signals towards an orbiting satellite.

An electrical signal may refer to a current or a voltage that is applied to, or input to, a device, such as an input-port of a switch. The input current or voltage may be varied in time. By varying the current or the voltage, information may be encoded or transmitted. The electrical signal may be an electrical signal used for powering the antenna as mentioned above. The electrical signal may be a transformed electrical signal used for powering the antenna as mentioned. The transforming of the electrical signal may be achieved by an AC to DC conversion device or an AC to AC conversion device. For example, an AC to DC conversion device may be a rectifier or a power supply unit. For example, an AC to AC conversion device may be a step-up transformer, or a step-down transformer, or a converter. Examples of an electrical signal are 12, or 24, or 48, or 120, 208, 220, 277, 240, 380, 400, 480 volts alternating current. Alternating current electrical signals may have a frequency. An example of the frequency is 60 Hertz, or 50 Hertz. Volts alternating current may be expressed as volts AC, or VAC. Further examples of an electrical signal are 12, or 24, or 48, or 120, or 240 volts direct current. Volts direct current may be expressed as volts DC or VDC.

A control unit may be a device for controlling switches by transmitting control signals to said switches. The control may be based on input-signals. Input-signals may comprise signals that are transmitted from the device for controlling a high-power amplifier to the control unit, and signals that are transmitted from an external device, for example a computer, to the control unit. The control unit may be connected to the device for controlling a high-power amplifier. The connection between the control unit and the device for controlling the high-power amplifier may be established through pins of the device for controlling the high-power amplifier. Here, a respective pin may be connected to a part of the device for controlling the high-power amplifier, e.g., to the first switch, to the second switch, to the third switch, or to the terminal block. The connection may be cable-based. In other words, the connection may be provided by cables. Stated differently, a cable may connect a respective pin to a respective part of the device for controlling a high-power amplifier. The control unit may have ports for receiving signals and ports for transmitting signals. The control unit may have one input-port or a plurality of input-ports and one output-port or a plurality of output-ports. The control unit may receive a signal, e.g., an electrical signal, or a fault indication, or a control signal, through the input-port. For example, the control unit may receive a fault indication. The control unit may transmit a signal, e.g., an electrical signal, or a control signal through the output-port to parts of the device for controlling a high-power amplifier. For example, the control unit may transmit a control signal to the second switch. The control unit may be provided with a sensing means, such as a sensor for sensing signals, and with generating means, such as a generator, for generating signals. Examples of a control unit are a micro-controller, MCU, a programmable logic controller, PLC, a digital signal processor, DSP, a field programmable gate array, FPGA, a central processing unit, CPU, or a computer.

According to the present embodiment, the third switch causes a transmission of a fault indication to the control unit.

A fault indication may be an electrical signal as discussed above. For example, an electrical signal may be 24 volts direct current, 24 vdc.

The third switch may cause a transmission of the fault indication by providing a connection between a first pin of the control unit and a second pin of the control unit. Here the first pin may be connected to an input terminal of the third switch and the second pin may be connected to the output terminal of the third switch. As a fault indication the control unit may apply a test signal, for example, a test voltage or a test current, between these pins at fixed time intervals. Thus, if the third switch provides a closed connection, the test signal is transmitted from the first pin to the second pin. The control unit may be configured to determine that there is a fault if the test signal is transmitted. Alternatively, the control unit may be configured to determine that there is a fault if the test signal is not transmitted. If the control unit receives the fault indication, the control unit may output a fault indication to a user. Moreover, if the control unit receives the fault indication, the control unit may turn the high-power amplifier off. For example, for turning off the high-power amplifier, the control unit may use one of the control mechanisms as discussed throughout the below embodiments.

According to the present embodiment, the second switch, K2, receives a control signal.

Here, a control signal may be an electrical signal as discussed above. For example, the second switch, K2, may receive a 24 volts direct current signal that is transmitted from the control unit to the second switch, K2.

According to the present embodiment, the second switch, K2, transmits an electrical signal to the first switch, K1. For example, the second switch, K2, upon receiving the control signal, may provide an electrical connection between the terminal block, TB1, and the first switch, K1. Based on the electrical connection between the terminal block, TB1, and the first switch, K1, an electrical signal present at the terminal block may be transmitted to the first switch via the second switch. Thereby, the first switch may be powered, or turned on, or turned off.

According to the present embodiment, if the first switch, K1, receives the electrical signal, the first switch, K1, turns the high-power amplifier on.

For example, the first switch, K1, upon, or in response to receiving the electrical signal, may provide an electrical connection between the plug and the receptacle. Thereby, the high-power amplifier may be powered on, or turned on.

Thanks to the solution of the first embodiment, a high-power amplifier can be controlled remotely and safely. Specifically, the combination of first switch and the second switch, K1 and K2, allows for efficient remote control of the high-power amplifier based on a control signal. For instance, by applying the control signal to the second switch, the high-power amplifier may be switched on. Moreover, using the third switch, K3, allows for efficient fault detection. This approach can replace conventional techniques using mechanical breakers and electro-mechanical switches, which cannot be operated remotely, are expensive and difficult to operate. Thereby, costs may be reduced, and respective control mechanism may be simplified.

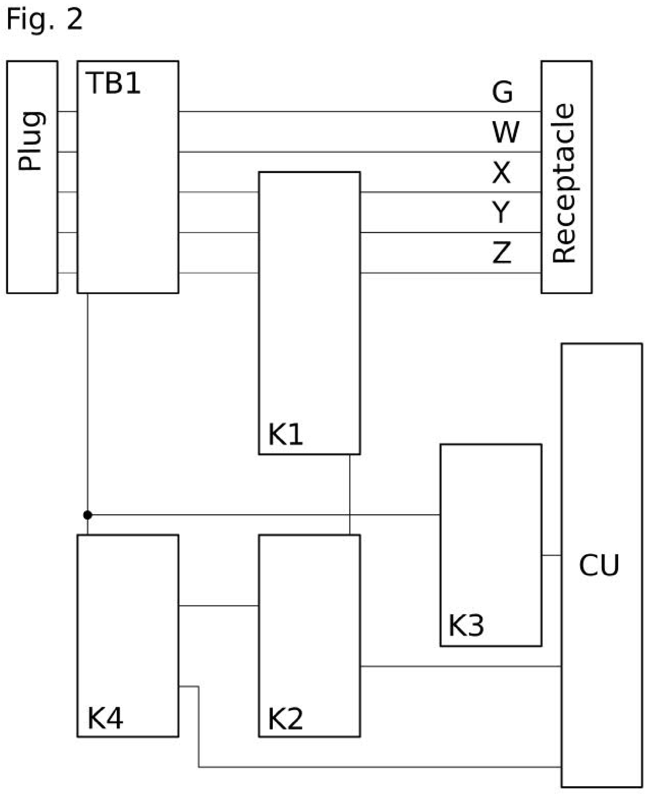

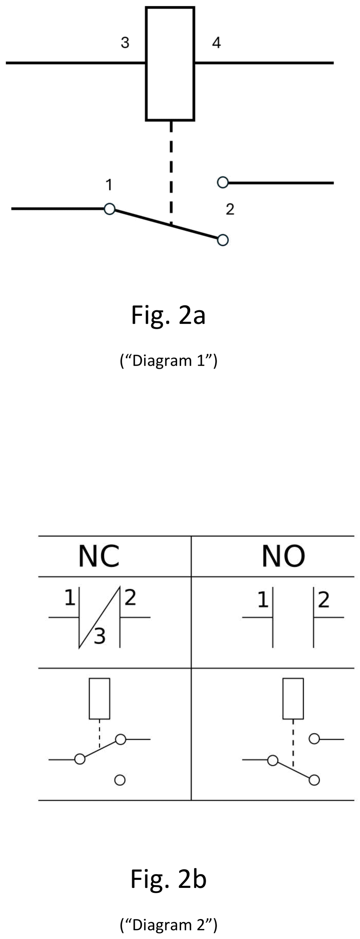

Figure 2 shows a second embodiment of the device for controlling a high-power amplifier, comprising the device of the first embodiment, and further comprising a fourth switch, K4, wherein the device is further configured so that, if the fourth switch, K4, receives a second control signal from the control unit, CU, the fourth switch, K4, prevents the second electrical signal from being transmitted by the second switch, K2.

The fourth switch may be a switch as discussed above. The fourth switch may be connected to the control unit. The fourth switch may be connected to the second switch. The fourth switch may be connected to the terminal block. The third switch and the fourth switch may be connected in parallel to the terminal block.

The second control signal may be a control signal as discussed above. The second control signal may be transmitted from the control unit to the fourth switch through the connection between the control unit and the fourth switch.

The second electrical signal is the second electrical signal as discussed with regards to the above first embodiment.

The fourth switch, K4, may prevent the second electrical signal from being transmitted by the second switch, K2. For example, the second switch may receive the second electrical signal via the fourth switch from the terminal block. For example, the fourth switch may receive the second electrical signal from the terminal block through an input terminal of the fourth switch. Then, the fourth switch may transmit the second electrical signal via a connection between the input terminal and the output terminal of the fourth switch to the output terminal of the fourth switch. The output terminal may be connected to the second switch. The transmission of the second electrical signal may thus be prevented by interrupting the connection between the input terminal and the output terminal of the fourth switch, for example, by switching the fourth switch off in response to receiving the second control signal.

As a technical advantage, the fourth switch allows for turning off the high-power amplifier remotely by using the control unit. Namely, a control unit may be operated remotely to transmit the second control signal to the fourth switch. Because of the second control signal, the fourth switch interrupts a connection between the terminal block and the second switch. Thereby, the second electrical signa is prevented from reaching the second switch via the fourth switch. Thus, the second electrical signal cannot be forwarded by the second switch, K2, to the first switch, K1. Then, if the first switch, K1, does not receive the second electrical signal, the first switch, K1, cannot turn the high-power amplifier on or may turn the high-power amplifier off.

A third embodiment of the device for controlling a high-power amplifier comprises the device of the second embodiment, wherein each switch is a relay.

Specifically, the first switch may be a first relay, the second switch may be a second relay, the third switch may be a third relay, and the fourth switch may be fourth relay.

In general, as depicted in the diagram 1 of Fig. 2a, a relay may be a configuration comprising a common terminal 1, an output terminal 2, a first contact 3, and a second contact 4. The common terminal 1 acts as an input terminal for inputting signals. The output terminal 2 acts as an output terminal for outputting signals, as its name suggests. Based on these terminals, a relay can connect two devices or cables connected to the respective terminals. For example, the terminal block may be connected to the common terminal of the fourth relay, and the output terminal of the fourth relay may be connected to the second relay. The contacts are used for powering a relay, or not, by applying a current that may enter the relay via the first contact 3 or the second contact 4, and, respectively, may exit the relay via the second contact 4, or the first contact 3. For example, as a control signal, the control unit may apply a current to the second contact of the fourth relay and the current may exit the fourth relay via the first contact.

The diagram 1 of Fig. 2a shows a relay-configuration comprising a common terminal 1, an output terminal 2, a first contact 3, and a second contact 4. The rectangle depicts a coil. Here, the first contact 3 may depict an input contact, where a current enters to the coil, and contact 4 depicts an output contact, where a current exits the coil. Based on the electromagnetic force generated by the current flowing through the coil, a connection between the common terminal 1 and the output terminal 2 may be either opened, interrupted, or closed, as further discussed below. The depicted relay is in a "normally open" configuration.

A relay can be configured in at least one out of two ways. In other words, a relay may be provided in a first way and in a second way. A first way is a "normally open", NO, configuration. A second way is a "normally closed", NC, configuration.

Normally open, NO, means that, by default, the common terminal is not connected to the output terminal, which means that there is an open connection between the common terminal and the output terminal when the coil of the relay is not powered, or provided with a current, through the contacts.

Normally closed, NC, means that, by default, the common terminal is connected to the output terminal, which means that there is a closed connection between the common terminal and the output terminal when the coil of the relay is not powered, or provided with a current through the contacts.

In both cases, the NC-configuration, or the NO-configuration, the configuration of the connection is reversed if the coil of the relay is powered.

For example, in the case of an NO configuration, the connection between the common terminal and the output terminal is closed when the coil of the relay is provided with a current. Moreover, in the case of an NC configuration, the connection between the common terminal and the output terminal is opened when the coil of the relay is provided with current. Diagram 2 of Fig. 2b shows sketches used for depicting relays and their respective configurations in circuit diagrams.

In each sketch depicted in the bottom line of the table according to the diagram 2 of Fig. 2b, a dot on the left-hand side denotes a relay's common terminal and the two dots on the right-hand side denote a relay's output terminal. A combination of a common terminal and an output terminal may be referred to as a terminal. In other words, the term "terminal" may comprise a common terminal and an output terminal. A relay may comprise one such terminal, or a plurality of these terminals. For example, a relay may comprise two terminals, wherein each terminal may have the same configuration or a different configuration. For example, a relay may comprise a first terminal in an NO configuration and a second terminal in an NC configuration. A relay may be in a normally closed configuration, as depicted by "NC", or a normally open configuration, as depicted by "NO".

In each diagram of the upper line of the table according to the diagram 2 of Fig. 2b, a vertical line, labelled 1, on the left-hand side of a respective sketch of an NC configuration or an NO configuration denotes a relay's common terminal. Moreover, a vertical line, labelled 2, on the right-hand side of a respective sketch of an NC configuration or an NO configuration denotes a relay's output terminal. A diagonal line, labelled 3, in between a respective pair of vertical lines, labelled 1 and 2, connecting the lower-left end of the line on the left-hand side and the upper-right end of the line on the right-hand side, as in the sketch in the left field in the upper line of the table according to diagram 2 of Fig. 2b, denotes a normal closed configuration. If the diagonal line is missing, as in the sketch in the right-hand side field of the upper line of the table according to diagram 2 of Fig. 2b, this denotes a normally closed configuration.

The above merely discusses illustrative examples and possible configurations of relays, for example, an electro-mechanical relay, and should not be taken as limiting the relays that may be used in the present embodiment.

Further examples of a relay are a solid-state relay, a reed relay, and a time delay relay.

As an advantageous effect of this embodiment, using relays results in a cost efficient and easy to maintain control mechanism.

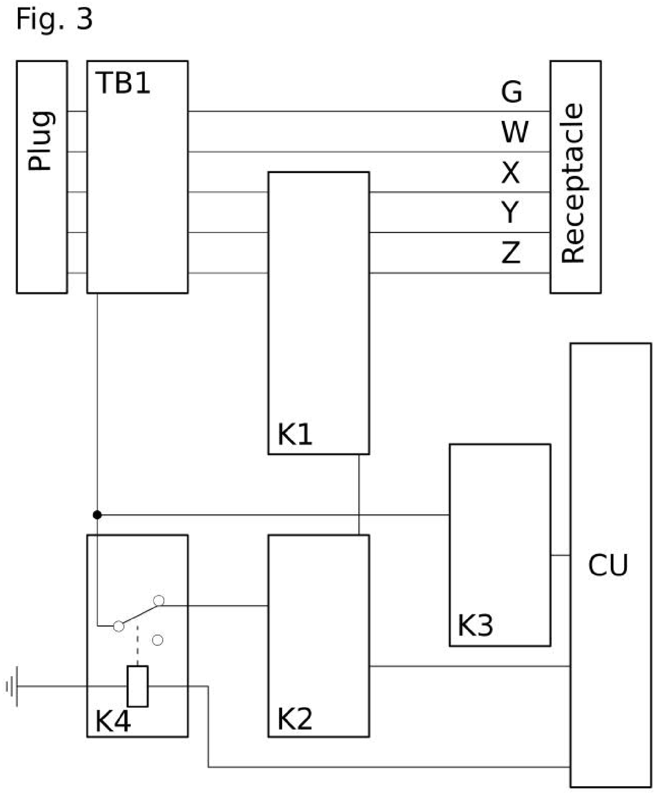

Figure 3 shows a fourth embodiment of the device for controlling a high-power amplifier comprising the device of the third embodiment, wherein the fourth relay, K4, comprises a common terminal that is connected to an output terminal of the terminal block, TB1, an output terminal that is connected to a common terminal of the second relay, K2, and an input contact that is connected to the control unit, CU, wherein the fourth relay, K4, is in a normally closed configuration.

As shown in figure 3, the output contact of the fourth relay may be connected to the ground.

In response to receiving the second control signal, from the control unit, the coil of the fourth relay is powered, and the relay changes the configuration of the connection between the common terminal and the output terminal is changed from closed to open. Thus, the second electrical signal is prevented from being transmitted from the terminal block via the fourth relay to the second relay, and thus cannot be transmitted by the second relay the first relay. Thus, the first relay is prevented from turning the amplifier on.

Thereby, as an advantage of this embodiment, this embodiment may provide a reliable and cost-efficient control mechanism for preventing the high-power amplifier from being switched on.

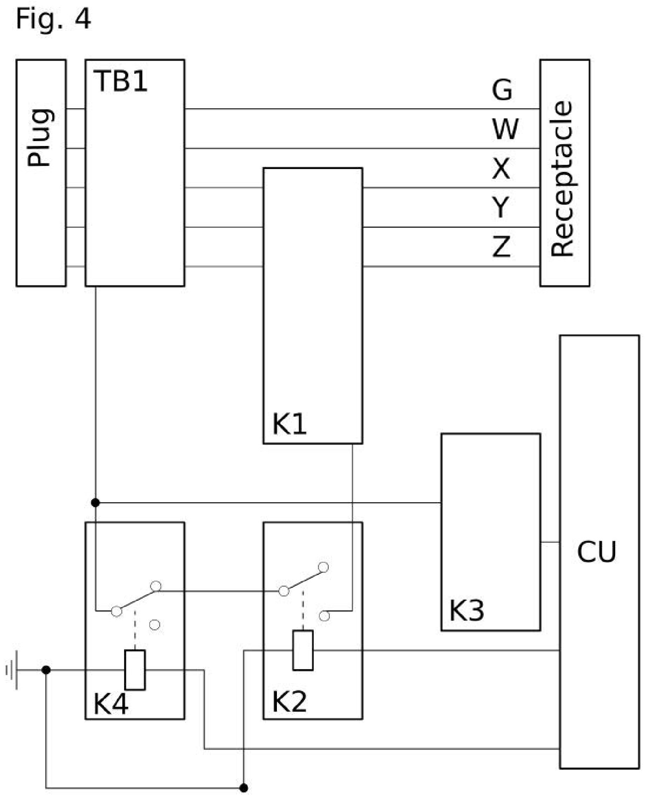

Figure 4 shows an example of a fifth embodiment of the device for controlling a high-power amplifier comprising the device of any of the third or the fourth embodiment, wherein the second relay, K2, comprises a common terminal that is connected to an output terminal of the fourth relay, K4, an output terminal that is connected to an input contact of the first relay, K1, and an input contact that is connected to the control unit, CU, wherein the second relay, K2, is in a normally open configuration.

Moreover, as depicted in figure 4, the second relay may comprise an output contact that is connected to the ground.

Because the second relay is in a normally open configuration, without the coil of the relay being powered, no current can flow from the terminal block through the fourth relay and through the second relay to the first relay. Now, if the coil is powered by the control signal that is provided by the control unit, the configuration of the connection between the common terminal and the output terminal is changed from open to closed, thereby providing a connection through which the current can flow to the first relay. Thus, as an advantage, by transmitting a control signal and stopping transmitting of the control signal, the high-power amplifier can be switched on and off remotely.

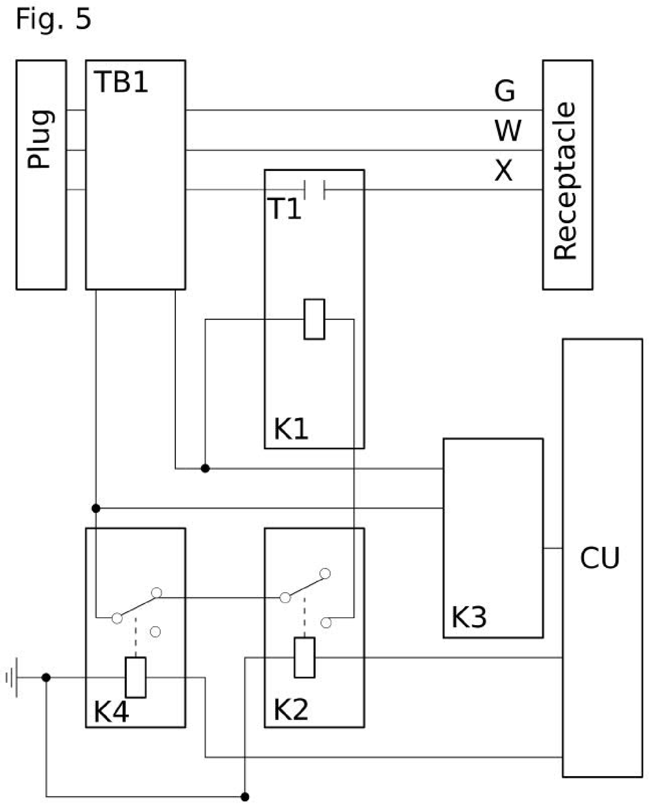

Figure 5 shows an example of a sixth embodiment of the device for controlling a high-power amplifier comprising the device of any one of the third to the fifth embodiment, wherein the first relay, K1, comprises a first terminal, T1, comprising a common terminal that is connected to an output terminal of the terminal block, TB1, and an output terminal that is connected to an input port of a receptacle, wherein the first terminal, T1, is in a normally open configuration, and the first relay, K1, further comprises an input contact that is connected to an output terminal of the second relay, K2, and an output contact that is connected to a second output port of the terminal block, TB1.

As shown in figure 5, the output contact of the first relay may be connected to the third relay.

If the coil of the first relay does not receive a current, the first terminal remains in the normally open configuration. Thus, the relay does not provide a connection between the plug and receptacle and no current can flow to a high-power amplifier connected to the receptacle. Now, if the coil of the first relay is powered by the second electrical signal from the second relay, the connection between the common terminal and the output terminal of the first relay is closed. Thus, the relay provides a connection between the plug and the receptacle, and a current can be provided from the plug to a high-power amplifier that is connected to the receptacle. Thus, advantageously, the present embodiment provides for a cost-efficient remote-control mechanism.

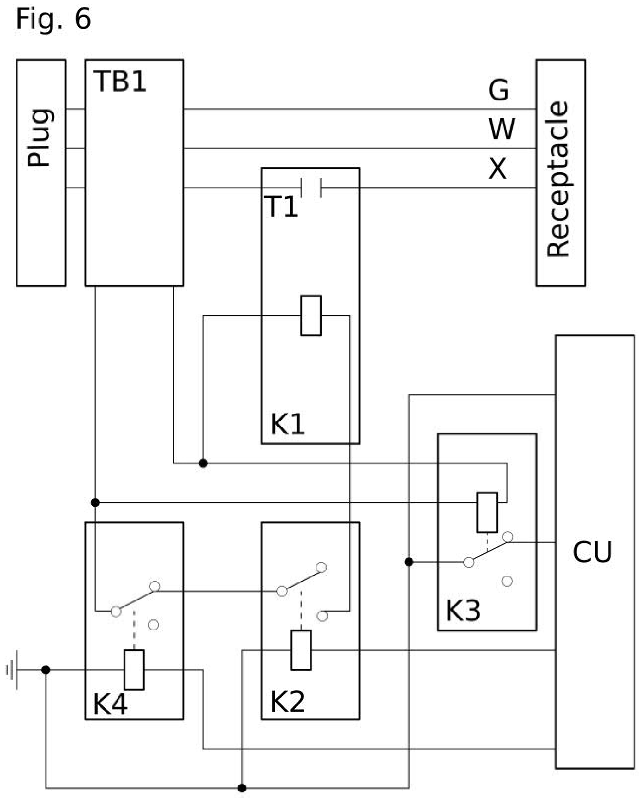

Figure 6 shows an example of a seventh embodiment of the device for controlling a high-power amplifier comprising the device of any one of the third to the sixth embodiment, wherein the third relay, K3, comprises a common terminal connected to the control unit, CU, an output terminal connected to the control unit, CU, an input contact connected to an output terminal of the terminal block, TB1, an output contact connected to a second output terminal of the terminal block, TB1, wherein the third relay, K3, is in a normally closed configuration or in a normally open configuration.

As shown in figure 6, the common terminal of the third relay may be connected to the ground. Moreover, the common terminal of the third relay, the output contact of the second relay, and the output contact of the fourth relay may be connected to the ground in parallel.

Figure 6 shows a configuration where the third relay is in a normally closed configuration. However, as indicated above, the third relay may also be in a normally open configuration, instead.

Assuming a normally closed configuration of the third relay, the control unit may determine whether the third relay is closed or open at fixed time intervals. That is, if a current, that is provided from the output terminal of the terminal block that is connected to the input contact of the coil, powers the coil, the connection between the relay's common terminal and output terminal is opened. Thus, if the control unit determines that this connection is closed, the control unit may be configured to output a fault notification, and to output a normal notification if the connection is open.

A corresponding concept applies to the case where the third relay is configured as normally open. In this case, the third relay being powered by a current provided from the terminal block means that the connection between the relay's common terminal and output terminal is closed. Thus, if the control unit determines that this connection is open, the control unit may be configured to output a fault notification, and to output a normal notification if the connection is closed.

Thus, as an advantage, this embodiment provides for a cost-efficient and material efficient mechanism for detecting faults remotely.

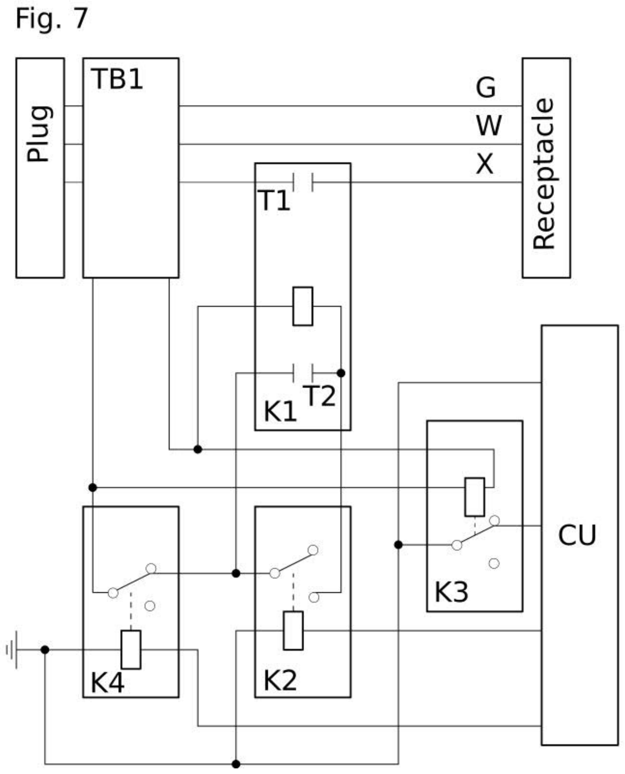

Figure 7 shows an example of an eighth embodiment of the device for controlling a high-power amplifier comprising the device of any one of the third to the seventh embodiment, wherein the first relay, K1, comprises a second terminal, T2, comprising a common terminal that is connected to an output terminal of the fourth relay, K4, and an output terminal that is connected to an input contact of the first relay, K1, wherein the second terminal is in a normally open configuration.

As depicted in figure 7, the common terminal of the second terminal may be connected to the common terminal of the second relay. The output terminal of the fourth relay and the common terminal of the second relay may be connected to the common terminal of the second terminal in parallel.

Moreover, as depicted in figure 7, the output terminal of the second terminal may be connected to the output terminal of the second relay. The input contact of the first relay and the output terminal of the second relay may be connected to the output terminal of the second terminal in parallel.

By default, the connections between the common terminal and the output terminal of the first terminal and the second terminal comprised by the first relay are open. Now, as discussed throughout the above embodiments, if the coil of the second relay is powered, for example, by receiving the control signal from the control unit, the second electrical signal is provided to the first relay, powering the coil of the first relay. Thereby, the connections between the common terminal and the output terminal of the first terminal and the second terminal of the first relay are closed. Without the second terminal, once the control unit does not provide the control signal to the second relay, the second electrical signal stops being transmitted from the second relay to the first relay, and the connection of the first terminal is opened, thereby interrupting a current flow from the plug to the receptacle, whereby a high-power amplifier connected to the receptacle may be switched off. Therefore, without the second terminal, for keeping the high-power amplifier powered, a constant control signal needs to be applied to the second relay. However, based on the second terminal, this disadvantage can be overcome. This is because the second terminal, once set to closed, provides an alternative path for providing a current from the terminal block through the fourth relay and the second terminal to the first relay. Thus, once the first relay is powered and the second terminal is closed, the high-power amplifier remains on irrespective of whether the control signal is transmitted from the control unit to the second relay, or not. In this case, the high-power amplifier may be switched off sending a second control signal from the control unit to the fourth relay, thereby interrupting the current flow from the terminal block to the second terminal of the first relay.

Thus, as an advantage, the present embodiment allows for controlling the high-power amplifier based on a momentary, non-constant, intermittent control signal, instead of a constant control signal. Thereby, the control mechanism is simplified, and wear of respective parts is reduced.

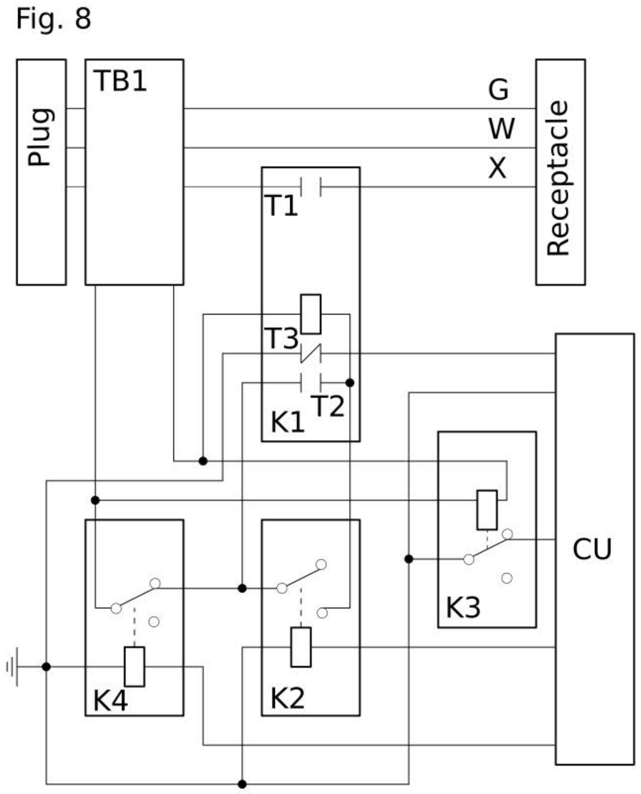

Figure 8 shows an example of a ninth embodiment of the device for controlling a high-power amplifier comprising the device of any one of the third to the eighth embodiment, wherein the first relay, K1, comprises a third terminal, T3, comprising a common terminal that is connected to the control unit, CU, and an output terminal that is connected to the control unit, CU, wherein the third terminal, T3, is in a normally closed configuration.

As shown in figure 8, the common terminal of the third terminal may be connected to the ground. Moreover, the common terminal of the third terminal may be connected to the output contact of the fourth relay. Furthermore, the common terminal of the third terminal may be connected to the output contact of the second relay. The common may be connected to the output contact of the fourth relay.

Here, based on the third terminal's common terminal and output terminal being connected to the control unit, for example, by applying a control signal at constant time intervals, the control unit can determine whether the connection between the common terminal and the output terminal of the third terminal is open or closed. The third terminal is in a normally closed configuration. Thus, when the coil of the first relay is powered, the connection between the common terminal and the output terminal of the third terminal is opened. If the first relay is powered, this means that a current is provided from the plug through the receptacle to the high-power amplifier. The control unit may thus detect that the high-power amplifier is switched on if the connection between the common terminal and the output terminal is open. Moreover, the control unit may detect that the high-power amplifier is switched off if the connection is closed. Thus, as an advantage, the present embodiment allows for a cost-efficient mechanism for monitoring whether the on/off state of the high-power amplifier.

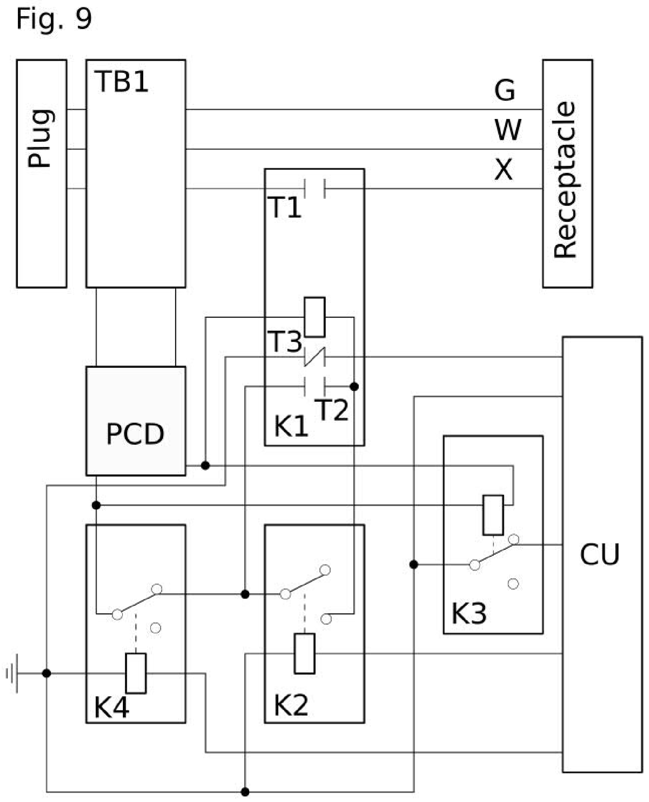

Figure 9 shows an example of a tenth embodiment of the device for controlling a high-power amplifier comprising the device of any one of the third to the ninth embodiment, wherein the first relay, K1, the third relay, K3, and the fourth relay, K4, are connected to the terminal block, TB1, via a power conversion device, PCD, and the power conversion device is a power supply unit, PS1, or a step-down transformer.

The power conversion device may comprise a first input terminal for receiving an input electrical signal and a first output terminal for outputting a converted electrical signal. The power conversion device may furthermore comprise a second input terminal for receiving the converted electrical signal and a second output terminal for outputting a re-converted electrical signal. For example, the power conversion device may receive an electrical signal from the terminal block through the first input terminal, convert this electrical signal to a converted electrical signal and output the converted electrical signal via the first output terminal. The converted electrical may then be the electrical signal or the second electrical signal as discussed throughout the above embodiments. The first input terminal may be connected to the terminal block. The first output terminal may be connected to the common terminal of the fourth relay or the input contact of the third relay. The second input terminal may be connected to the output contact of the first relay, the common terminal of the third terminal of the first relay, the common terminal of the second terminal of the first relay, or the output contact of the third relay. The second output terminal may be connected to the terminal block. As depicted in figure 9, some of the connections may be in parallel.

The power supply unit may be configured to convert an alternating current signal, which is an example of an input electrical signal, to a direct current signal, which is an example of converted electrical signal. For example, the power supply unit may convert a 120 volts alternating current, 120 VAC, signal to a 24 volts direct current, 24 VDC, electrical signal. The converted electrical signal may then be transmitted to the fourth relay and the third relay and used for controlling and monitoring the high-power amplifier. After having passed through the respective relays, the converted electrical signal may be transmitted to the second input terminal, reconverted by the power supply unit to an alternating current electrical signal, and then output by the second output terminal.

The step-down transformer may be configured to convert an alternating current signal, which is an example of an input electrical signal, to a converted alternating current signal, which is an example of converted electrical signal. For example, the power supply unit may convert a 120 volts alternating current, 120 VAC, signal to a 24 volts alternating current, 24 VAC, electrical signal. The converted electrical signal may then be transmitted to the fourth relay and the third relay and used for controlling and monitoring the high-power amplifier. After having passed through the respective relays, the converted electrical signal may be transmitted to the second input terminal, and after being processed by the step-down transformer, output by the second output terminal as a re-converted electrical signal to the terminal block.

As an advantage of this embodiment, using the above power conversion devices for adapting the electrical signals before using them for control and monitoring the high-power amplifier results in increased security, reduced interference and reduced risk of damages or injuries during maintenance of the device for control controlling the high-power amplifier.

An eleventh embodiment comprises the device for controlling a high-power amplifier comprising the device of any one of the first to the tenth embodiment, wherein a respective control signal is selected from a range from 4 to 30 volts direct current, more preferably from a range from 10 to 25 volts direct current, most preferably from a range from 12 to 24 volts direct current, or wherein a respective control signal is selected from a range from 10 to 400 volts alternating current, more preferably from a range from 10 to 130 volts alternating current, most preferably from a range from 20 to 50 volts alternating current.

A respective control signal may be the control signal that is received by the second switch from the control unit, or the second control signal that is received by the fourth switch, as discussed with regards to the above and the below embodiments.

Both control signals may be selected according to one of the above options. Moreover, each control signal may be selected according to one of the above options, individually. For example, the control signal and second control may both be selected as 24 volts alternating current signal. As another example, the control signal may be selected as 24 volts alternating current signal and the second control signal may be selected as 20 volts alternating current signal.

As an advantage of this embodiment, selecting the control signals in the above ranges results in increased security, reduced interference and reduced risk of damages or injuries during maintenance of the device for control controlling the high-power amplifier.

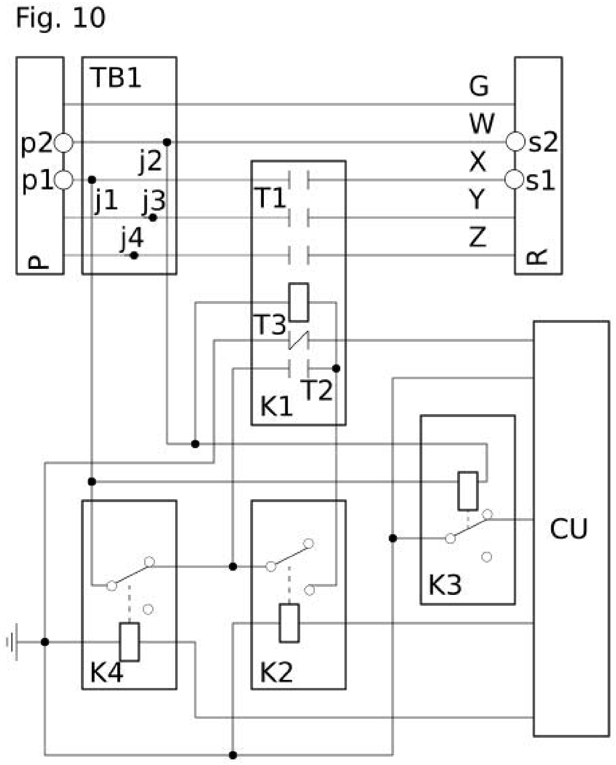

Figure 10 shows an example of a twelfth embodiment of the device for controlling a high-power amplifier comprising the device according to any one of the second to the eleventh embodiment, wherein the device further comprises the terminal block, TB1, the terminal block, TB1, comprising a first junction, j1, that connects a hot prong, p1, of a plug, P, the first switch, K1, the third switch, K3, and the fourth switch, K4, and a second junction, j2, that connects a neutral prong, p2, of the plug, P, a neutral slot, s2, of a receptacle, R, the first switch, K1, and the third switch, K3, wherein the first switch, K1, is connected to the hot slot, s1, of the receptacle, R.

In figure 10, white circles labelled p1, p2 represent a respective prong of the plug P, and white circle labelled s1, s2 represent a respective slot of the receptacle R. A slot may be referred to as a contact, as mentioned throughout the above embodiments.

As depicted in figure 10, the second junction j2 provides a connection between the neutral prong p2, the neutral slot s2, the first switch K1 and the third switch K3. The connection may be referred as a neutral connection, as often denoted by W in circuit diagrams. Based on the connection provided by the terminal block via the second junction, a current may be fed back from the receptacle, which may be connected to the high-power amplifier, to the plug. Moreover, a current may be fed back from the first switch or the third switch via the junction to the plug.

As depicted in figure 10, the first junction j1 provides a connection between the hot prong p1, the first switch K1, the third switch K3, and the fourth switch K4. The connection may be referred to as a hot connection, or hot wire. Based on this connection, a current may be fed from the plug to the third switch, or to the fourth switch. Moreover, based on this connection a current may be fed from the plug to the receptacle via the first switch. For example, a current may be fed via the first terminal T1 comprised in the first relay as discussed in one of the above embodiments. Thereby, a high-power amplifier that is connected to the receptacle may receive the current. The current may be a one-phase current, a multi-phase current, or a three-phase current. In figure 10, the connection provided by the first junction j1 may transmit the first phase of a three-phase current, as denoted X.

The terminal block may comprise further junctions that are configured like the first junction but are connected to other prongs and slots, thereby providing further connections. Each of the further connections may transmit a further phase of a multi-phase system or a three-phase system. For example, as depicted in figure 10, a third junction j3 and a fourth junction j4 may be considered, wherein the third junction may provide a connection denoted Y for supplying the second phase of a multi-phase current from the plug via the first switch to the receptacle, and wherein the fourth junction may provide a connection denoted Z for supplying the third phase of a multi-phase current from the plug via the first switch to the receptacle. The third junction j3 may be connected to any one of the four switches. The fourth junction j4 may be connected to any one of the four switches. Based on the electrical signals provided by the third junction or the fourth junction being provided to one of the switches, additional control mechanisms and monitoring mechanisms may be implemented.

As depicted in figure 10, the plug and the receptacle may be connected by a ground connection, denoted by G, provided between a ground prong of the plug and a ground slot of the receptacle.

Each connection may be cable-based, for example by connecting a cable to the respective prongs, slots, and the input and output parts of the switches.

Non-limiting examples of junctions that may be used comprise a screw-type junctions, a spring-clamp junction, a push-in junction, a bolt-type junction, a lever-type junction, a barrier junction, an insulation displacement connection junction, a rising cage clamp junction, a rail mounted junction.

Moreover, as depicted in figure 10, if the first switch is a relay, the first junction may be connected to a common terminal of a first terminal comprised by the first relay. Moreover, if the third switch is a relay, the first junction may be connected to an input contact comprised by the third relay. Moreover, if the fourth switch is a relay, the first junction may be connected to a common terminal comprised by the fourth relay.

Furthermore, as depicted in figure 10, if the first switch is a relay, the second junction may be connected to an output contact comprised by the first relay. Moreover, if the third switch is a relay, the second junction may be connected to an output contact comprised by the third relay.

Moreover, the device according to this embodiment or any other embodiment may comprise the plug or the receptacle, or the plug and the receptacle.

As an advantage of the present embodiment, using the terminal block according to this embodiment allows for an easy way of connecting the device for controlling a high-power amplifier with a power source via the plug and with the high-power amplifier via the receptacle.

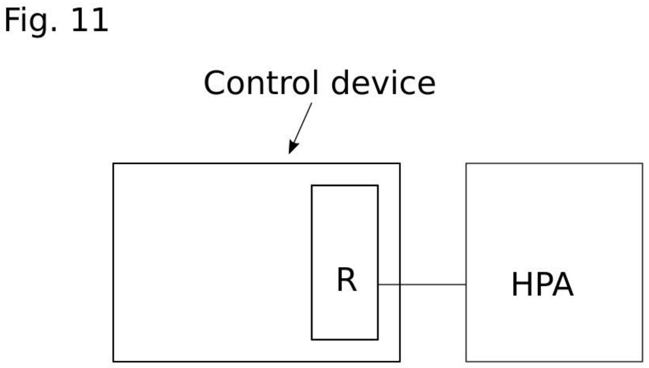

Figure 11 shows a thirteenth embodiment of the present invention, providing a system comprising the device for controlling a high-power amplifier of the twelfth embodiment, and a high-power amplifier, HPA, the high-power amplifier being connected to the receptacle, R.

As shown in figure 11, the device, Control Device, may comprise the receptacle. The high-power amplifier is connected to the receptacle, for example, by a cable. For example, the high-power amplifier may comprise a plug that is connectable to the receptacle, Thereby, the high-power amplifier may be connected to the device for controlling the high-power amplifier and a current may be provided via the control device to the high-power amplifier. Moreover, by providing control signals as mentioned throughout the above embodiments to the switches comprised by the control device, power supply of the high-power amplifier may be controlled remotely.

As an advantage, the system comprising the control device being connected to a high-power amplifier allows for secure remote control and monitoring of the connected high-power amplifier.

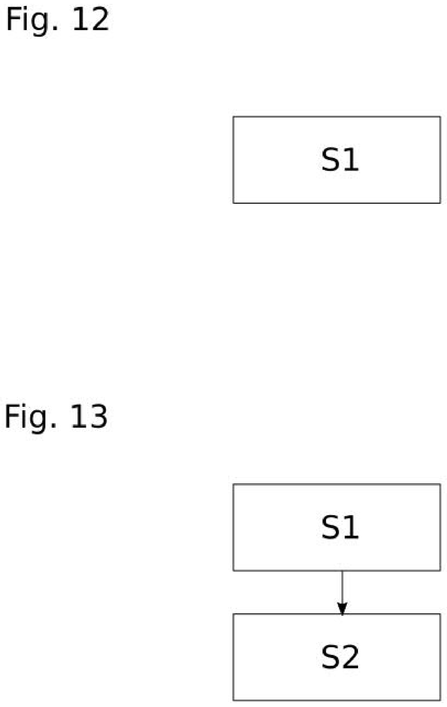

Figure 12 shows a flowchart corresponding to a fourteenth embodiment of the present invention providing a method for controlling a high-power amplifier using the device of any one of the first embodiment to the twelfth embodiment, the method comprising a first step, S1, of, by using the control circuit, CU, sending the control signal to the second switch, K2.

The method may be computer implemented.

There may be a data processing apparatus comprising means for carrying out the steps of the method.

There may be a computer program product comprising instructions which, when the program is executed by a computer, cause the computer to carry out the steps of the method.

There may be a computer-readable storage medium comprising instructions which, when executed by a computer, cause the computer to carry out the steps of the method.

The control circuit may be operated directly or by a computer, thereby instructing the control circuit to send the control signal to the second switch.

As an advantage of the present embodiment, sending the control signal to the second switch, allows switching on the high-power amplifier remotely.

Figure 13 shows a flowchart corresponding to a fifteenth embodiment of the present invention providing a method of the fourteenth embodiment, the method comprising a second step, S2, of, by using the control circuit, CU, sending the second control signal to the fourth switch, K4.

The control circuit may be operated directly or by a computer, thereby instructing the control circuit to send the second control signal to the fourth switch.

As indicated by the arrow pointing from step S1 to step S2, the second step S2 may be performed after the first step S1.

As an advantage of the present embodiment, sending the second control signal to the second switch, allows switching off the high-power amplifier remotely.

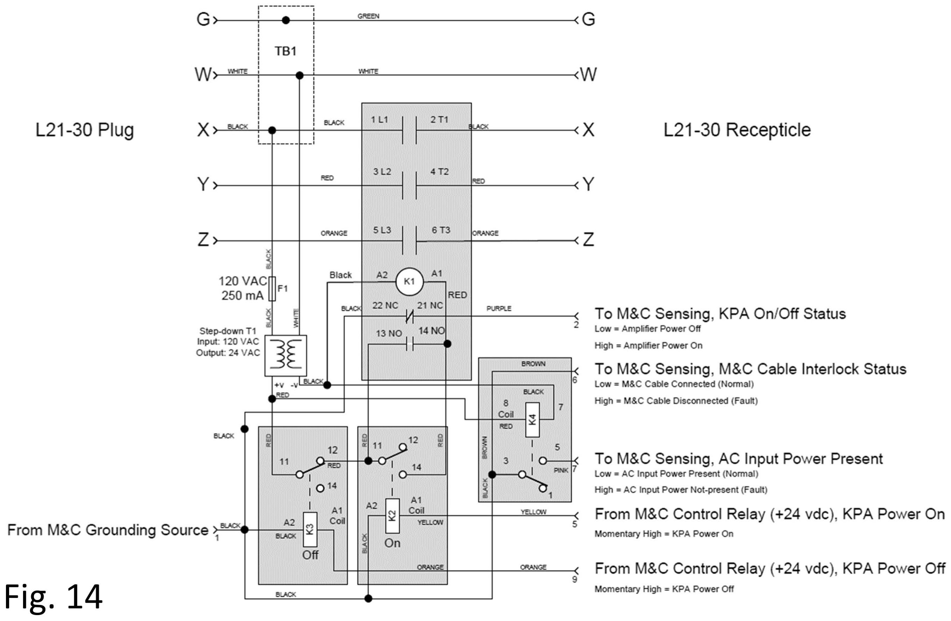

Figure 14 shows another embodiment of a device for controlling a high-power amplifier according to the present invention. Here, the plug as mentioned throughout any one of the other embodiments is an L21-30 plug, and the receptacle as mentioned throughout any one of the other embodiments is an L21-30 receptacle. Moreover, the control until as mentioned throughout any of other embodiments is implemented as a monitoring and control, M&C sensing out, an M&C control relay, and an M&C grounding source being connected to relays K1, K2, K3, K4. Via pins 1, 2, 5, 6, 7, and 9. In comparison to the other figures as mentioned above, the relay indicated as K4 in the figure 14 is the third relay K3 as depicted throughout the above-mentioned figures 1 to 10. This figure further shows that the above embodiment that involves a step-down transformer T1 may further comprise a resistor F1 that is placed in between the second junction of the terminal block TB1 and the step-down transformer T1. This resistor may be configured such that the current provided from the plug through the junction to a step-down transistor is 120 volts alternating current and 250 milli ampere.

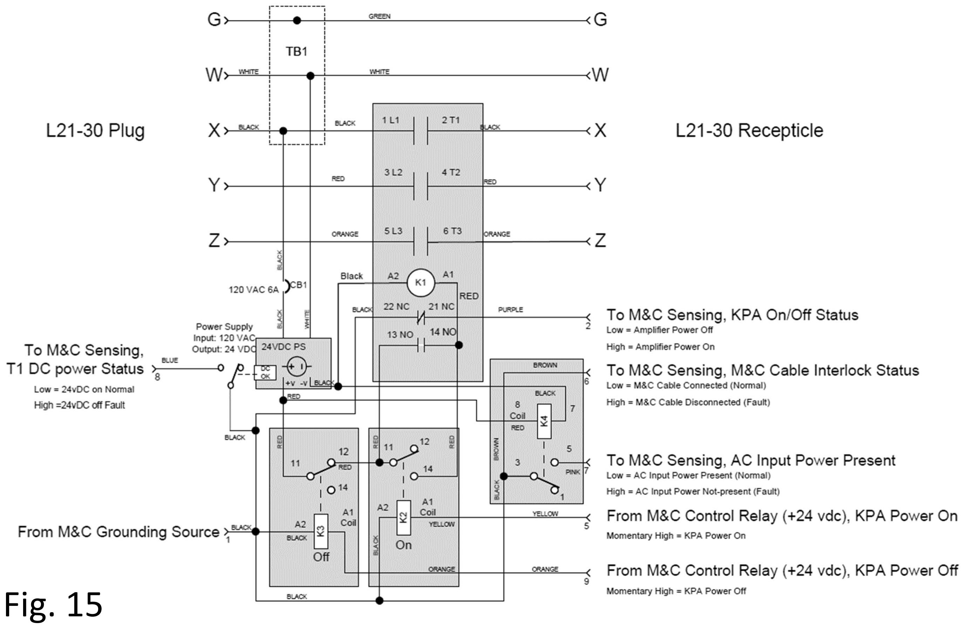

Figure 15 shows another embodiment of a device for controlling a high-power amplifier according to the present invention. The configuration is similar to the configuration shown in figure 14 but for the following differences. Instead of step-down transformer, a power supply unit is placed in between the terminal block TB1 and the relays. The power supply unit may comprise a further relay in a normally open configuration. This relay may also be in a normally closed configuration. If the power supply unit does not work properly, for example, due to a fault, no current flows through the power supply unit and, if the relay is in a normally closed configuration, the relay is closed. Based on the closed connection, the M&C sensing may determine that a current can be received at pin 8, wherein the M&C sensing, which is an example of the control unit as mentioned throughout the embodiment, may be configured to determine that there is a fault if a current can be received at pin 8. Moreover, the device shown in figure 15 may comprise a circuit breaker CB1 configured to a break at 120 volts alternating current and 6 ampere electric current.

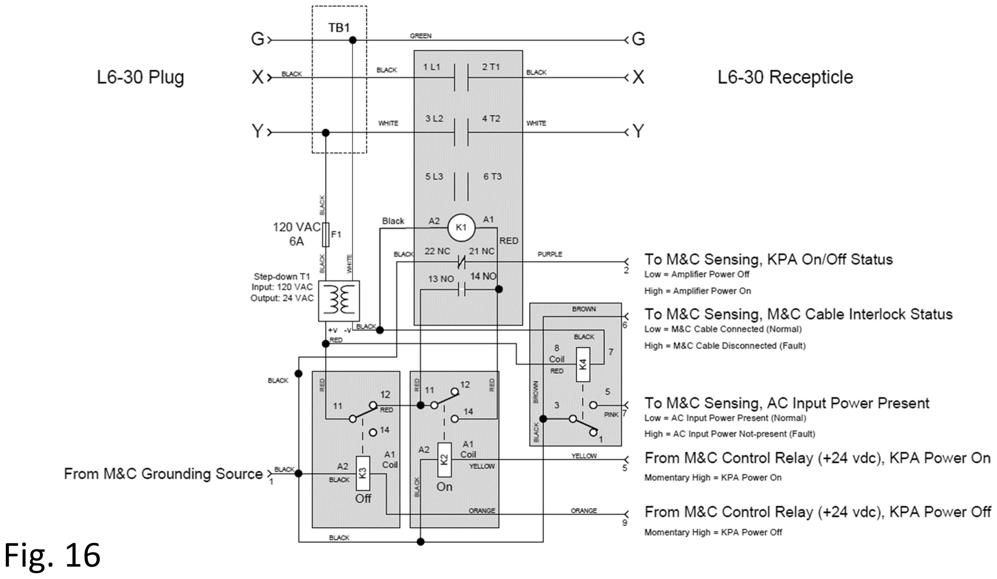

Figure 16 shows another embodiment of a device for controlling a high-power amplifier according to the present invention. The configuration is similar to the configuration shown in figure 14 but for the following differences. In figure 16, the plug is a L6-30 plug, and receptacle is a L6-30 receptacle. Moreover, the terminal block TB1 comprises a first junction connected to a ground prong of the plug and a ground slot of the receptacle and further, via the step-down transformer T1, connected to the first relay K1 and the third relay K3, which in figure 16 is depicted as K4. Moreover, the terminal block comprises a second junction that is connected second phase, Y-phase, prong of the plug and, via a terminal of the first relay, to a Y-phase slot of the receptacle. The second junction may further be connected to the step-down transformer via the resistor as depicted in figure 16.

Each of the above embodiments or any detail discussed with regards to any of the above embodiments may be combined with any one of the other embodiments as discussed above.

Although the present invention has been described in detail above, it should be obvious to a person skilled in the art that the present invention is by no means limited to the embodiments described in this specification. The present invention can be implemented with various corrections and in various modifications, without departing from the spirit and scope of the invention defined by the recitations of claims. Consequently, the description in this specification is provided only for the purpose of explaining examples, and should by no means be construed to limit the invention according to the present invention in any way.

## Claims

1. A device for controlling a high-power amplifier, the device comprising:
a first switch, a second switch, and a third switch;
wherein the device is configured so that:
if the third switch does not receive an electrical signal from a terminal block, the third switch causes a transmission of a fault indication to a control unit; and
if the second switch receives a control signal from the control unit, the second switch transmits a second electrical signal to the first switch; and
if the first switch receives the second electrical signal, the first switch turns the high-power amplifier on.

2. The device of claim 1, the device further comprising:
a fourth switch wherein the device is further configured so that, if the fourth switch receives a second control signal from the control unit, the fourth switch prevents the second electrical signal from being transmitted by the second switch.

3. The device of claim 2, wherein each switch is a relay.

4. The device of claim 3, wherein the fourth relay comprises
a common terminal that is connected to an output port of the terminal block,
an output terminal that is connected to a common terminal of the second relay, and an input contact that is connected to the control unit,
wherein the fourth relay is in a normally closed configuration.

5. The device of any one of claims 3 and 4, wherein the second relay comprises
a common terminal that is connected to an output terminal of the fourth relay,
an output terminal that is connected to an input contact of the first relay, and
an input contact that is connected to the control unit,
wherein the second relay is in a normally open configuration.

6. The device of any one of claims 3 to 5, wherein the first relay comprises
a first terminal, comprising a common terminal that is connected to an output terminal of the terminal block, and an output terminal that is connected to an input port of a receptacle, wherein the first terminal is in a normally open configuration, and
the first relay further comprises
an input contact that is connected to an output terminal of the second relay, and
an output contact that is connected to a second output port of the terminal block.

7. The device of any one of claims 3 to 6, wherein the third relay comprises
a common terminal connected to the control unit,
an output terminal connected to the control unit,
an input contact connected to an output terminal of the terminal block,
an output contact connected to a second output terminal of the terminal block, wherein
the third relay is in a normally closed configuration or in a normally open configuration.

8. The device of any one of claims 3 to 7, wherein the first relay comprises
a second terminal, comprising a common terminal that is connected to an output terminal of the fourth relay and an output terminal that is connected to an input contact of the first relay,
wherein the second terminal is in a normally open configuration.

9. The device of any one of claims 3 to 8, wherein the first relay comprises
a third terminal comprising a common terminal that is connected to the control unit and an output terminal that is connected to the control unit,
wherein the third terminal is in a normally closed configuration.

10. The device of any one of claims 3 to 9, wherein the first relay, the third relay and the fourth relay are connected to the terminal block via a power conversion device, and the power conversion device is a power supply unit, or a step-down transformer.

11. The device of any one of claims 1 to 10, wherein
wherein a respective control signal is selected from a range from 4 to 30 volts direct current, more preferably from a range from 10 to 25 volts direct current, most preferably from a range from 12 to 24 volts direct current, or
wherein a respective control signal is selected from a range from 10 to 400 volts alternating current, more preferably from a range from 10 to 130 volts alternating current, most preferably from a range from 20 to 50 volts alternating current.

12. The device of any one of claims 2 to 11, further comprising the terminal block, the terminal block comprising:
a first junction that connects a hot prong of a plug, the first switch, the third switch and the fourth switch; and
a second junction that connects a neutral prong of the plug, a neutral slot of a receptacle, the first switch, and the third switch, wherein
the first switch is connected to the hot slot of the receptacle.

13. A system comprising the device of claim 12, and a high-power amplifier, the high-power amplifier being connected to the receptacle.

14. A method for controlling a high-power amplifier using the device of one of claims 1 to 12, the method comprising a first step of:
by using the control circuit, sending the control signal to the second switch.

15. The method of claim 14, the method comprising a second step of:
by using the control circuit, sending the second control signal to the fourth switch.
